**Europäisches Patentamt**

**European Patent Office**

**Office européen des brevets**

(19)

(11) Veröffentlichungsnummer: **0 216 113**
**B1**

# (12) EUROPÄISCHE PATENTSCHRIFT

(45) Veröffentlichungstag der Patentschrift:
31.10.90

(21) Anmeldenummer: 86111270.4

(22) Anmeldetag: 14.08.86

(51) Int. Cl.⁵: **G11B 20/16, G11B 5/012,**
**G11B 27/10, G11B 20/10,**
**H03K 5/135**

(54) **Synchronisierungseinrichtung.**

(30) Priorität: 19.08.85 DE 3529648

(43) Veröffentlichungstag der Anmeldung:
01.04.87 Patentblatt 87/14

(45) Bekanntmachung des Hinweises auf die Patenterteilung:
31.10.90 Patentblatt 90/44

(84) Benannte Vertragsstaaten:
AT CH DE FR GB IT LI NL SE

(56) Entgegenhaltungen:
DE-A- 1 917 003
DE-A- 2 224 391
DE-A- 2 246 590
GB-A- 2 091 522
US-A- 3 123 810
US-A- 3 537 075
US-A- 3 810 235
US-A- 4 039 960
US-A- 4 191 976
US-A- 4 380 736

PATENTS ABSTRACTS OF JAPAN, Band 8,
Nr. 33 (P-254)[1470], 14. Februar 1984; &
JP-A-58 188 316 (TOKYO SHIBAURA DENKI
K.K.) 02-11-1983

(73) Patentinhaber: Siemens Aktiengesellschaft,
Wittelsbacherplatz 2, D-8000 München 2(DE)

(72) Erfinder: Spengler, Werner, Dr.rer.nat.,
Josef-Lutz-Weg 23, D-8000 München 70(DE)
Erfinder: Kranabetter, Johann, Dipl.-Ing.,
Turnerweg 21 d, D-8200 Rosenheim(DE)

## Beschreibung

Die Erfindung bezieht sich auf eine Synchronisierungseinrichtung zum Erzeugen einer synchronisierten Impulsfolge gemäß dem Oberbegriff des Hauptanspruches.

Synchronisierungseinrichtungen sind in einer Vielzahl von Ausführungsformen, angepaßt an die verschiedensten Anwendungsfälle, bekannt. Im allgemeinen kommt es dabei darauf an, mit Hilfe einer solchen Synchronisierungseinrichtung eine extern zugeführte Signalfolge in einer empfangenden Einrichtung synchron zu einem internen Arbeitsablauf zu verarbeiten, d. h. die empfangene Signalfolge mit einem internen Arbeitstakt zu synchronisieren, ohne daß dabei ein Informationsverlust der empfangenen Signalfolge eintritt. Ein Sonderfall im Anwendungsgebiet kann dann darin bestehen, daß der der externen Signalfolge zugrundeliegende Takt mit diesem internen Arbeitstakt der empfangenden Einrichtung der Frequenz nach exakt übereinstimmt, die empfangene Signalfolge also nur der Phase nach vom internen Arbeitstakt verschieden sein kann.

Dem vorliegenden Fall ist diese Voraussetzung mit der weiteren Randbedingung zugrundegelegt, daß die absolute Phasendifferenz nicht begrenzt ist, also auch in der Größenordnung einer Taktperiode oder sogar darüber liegen kann. Ein solcher Anwendungsfall liegt häufig vor, wenn bei nachrichten- oder spezieller datenverarbeitenden Systemen eine zentrale Steuerung einen zentralen Takt vorgibt und periphere Einrichtungen in ihrer Arbeitsgeschwindigkeit an diesen zentralen Takt angepaßt sind. Ohne daß dies hier eine besondere Rolle spielte, gibt es verschiedene Möglichkeiten, die Takte in den einzelnen Einheiten eines solchen Systemes der Frequenz nach konstant zu halten oder einem Referenztakt anzupassen. Kritisch bleibt jedoch immer die Phasendifferenz der Takte an verschiedenen Orten, wegen unterschiedlicher Laufzeiten in einzelnen Einheiten eines solchen Systemes und der Phasenlaufzeiten auf Übertragungsstrecken.

Ein solches Problem liegt z. B. bei einem aus der DE-OS I9 I7 OO3 bekannten Verfahren zur Taktsynchronisierung bei der Datenübertragung in einem Datenwählnetz für synchronen und arhythmischen Betrieb der Teilnehmer vor. Hier ist an einer zentralen Stelle im Datenwählnetz ein Taktgenerator angeordnet, der über einen eigenen, vom Datennetz unabhängigen Übertragungsweg zu jedem Teilnehmer, der Synchronbetrieb durchzuführen wünscht, Taktsignale aussendet. In diese Übertragungswege ist jeweils ein Laufzeitglied eingeschaltet, dessen Laufzeit die Laufzeit des Übertragungsweges auf ganze Vielfache des zeitlichen Abstandes zweier aufeinanderfolgender Taktimpulse ergänzt. Außerdem ist in jeden von Synchronteilnehmern zu benutzenden Vermittlungsabschnitt des Datennetzes ein Laufzeitglied eingeschaltet, dessen Laufzeit einerseits die Laufzeit des Abschnittes auf ganze Vielfache des zeitlichen Abstandes zweier aufeinanderfolgender Taktimpulse ergänzt und andererseits die Nachricht in den Vermittlungsämtern und bei den Teilnehmern zeitlich so verschiebt, daß sie phasenrichtig zum Takt liegt.

Es ist einleuchtend, daß ein derartiger Ausgleich unterschiedlicher Phasendifferenzen an einzelnen Empfangsorten aufwendig ist und nur dann gerechtfertigt erscheint, wenn das gesamte Netz auf einen Langzeitbetrieb ausgerichtet ist. In vielen anderen Anwendungsfällen, z. B. bei kleineren datenverarbeitenden Systemen mit peripheren Geräten, soll es möglich sein, die Standorte solcher peripherer Geräte ohne besondere Rücksicht auf Laufzeiten zu wählen und auch zu ändern, so daß keine zu hohen Installationskosten auftreten.

Wenn man den Ausgleich von Phasenabweichungen aufgrund von unterschiedlichen Laufzeiten über Übertragungswege nicht über solche Maßnahmen wie eben beschrieben vornehmen will, dann muß man Synchronisierungseinrichtungen vorsehen, die übertragene Signalfolgen, bei datenverarbeitenden Geräten insbesondere Signalimpulsfolgen auf den internen Arbeitstakt am jeweiligen Empfangsort synchronisieren. In diesem Zusammenhang ist z.B. aus der DE-A 2 246 590 eine Synchronisationsschaltung mit zwei bistabilen Schaltstufen bekannt, die als flankengesteuerte JK-Flipflops ausgebildet sind. Beide Flipflops sind bezüglich der Ausgänge des einen und der Vorbereitungseingänge des anderen in Serie geschaltet und werden gemeinsam durch eine der Flanken des internen Arbeitstaktes gesteuert. Die zu synchronisierende Signalimpulsfolge kann nun in unterschiedlicher Weise z.B. über vorgeschaltete Verknüpfungsglieder den Vorbereitungseingängen dieser bistabilen Schaltstufen zugeführt werden. Ein Nachteil dieser bekannten Synchronisationsschaltung besteht darin, daß bestimmte Randbedingungen des Taktverhältnisses der Eingangsimpulsfolge eingehalten werden müssen, damit diese Schaltungen sicher arbeiten. Dies ergibt sich augenscheinlich daraus, daß die beiden seriell verbundenen Schaltstufen jeweils durch eine Taktflanke ausgelöst werden und sich deshalb der Signalzustand in einem kritischen zeitlichen Bereich, vorgegeben durch Vorbereitungs- und Haltezeiten (set up and hold) der entsprechenden bistabilen Schaltstufen, der zu beiden Seiten der auslösenden Taktflanke liegt, nicht ändern darf, ohne daß es zu undefinierten Schaltzuständen kommt.

Aus JP-A-58-188 316 ist weiterhin eine Synchronisierungseinrichtung bekannt, bei der eine externe Datenimpulsfolge mit dem ihr entsprechenden externen Takt in einem D-Flipflop zwischengespeichert und anschließend mit einem internen Takt gleicher Frequenz, jedoch abweichender Phasenlage in ein Register zur weiteren Verarbeitung übernommen wird. Zum Aufsynchronisieren des internen Arbeitstaktes auf den externen Takt ist ein Schaltnetzwerk, bestehend aus weiteren Flipflops, vorgesehen. Eines dieser Flipflops könnte man als Zustandsflipflop bezeichnen. Es übernimmt, gesteuert durch den externen Takt, an seinem Dateneingang ein Zustandssignal, das die Synchronisierungseinrichtung aktiviert bzw. deaktiviert. Im aktivierten Zustand gibt dieses Zustandsflipflop ein statisches Signal an ein weiteres, nachgeschaltetes D-Flipflop ab, das dieses Signal mit der nächsten Taktflanke vorbestimmter Richtung einer internen Taktimpulsfolge übernimmt und mit seinem Ausgangssignal den Setzeingang eines nachgeschalteten JK-Flipflops deaktiviert, das damit freigegeben wird. Dieses JK-Flipflop wird ebenfalls mit der internen Taktimpulsfolge angesteuert, ändert aber seinen Signalzustand immer mit der gegenüber der Taktflanke vorbestimmten Richtung um 180° phasenversetzten Taktflanke.

Die bekannte Synchronisierungseinrichtung hat also zwei Zustände, einen Ruhe- und einen Betriebszustand, die durch das statische Zustandssignal definiert sind. Beim Umschalten auf den Betriebszustand wird zunächst auf die nächste Takt-flanke der internen Taktimpulsfolge einsynchroni-siert und dann unabhängig vom externen Takt die selektierte Phasenlage der internen Taktimpulsfolge als Phasenlage des internen Arbeitstaktes gehalten. Kritisch ist bei dieser Lösung das Schaltverhalten des zweiten D-Flipflops. Sollte sich hier am Dateneingang der Signalzustand ändern, während der steuernde Taktimpuls ansteht, ergibt sich ein für D-Flipflops nicht zugelassener instabiler Zustand, der die Synchronisierung erschwert und gegebenenfalls zu einem Datenverlust führen kann. Diese bekannte Lösung zeigt die Problematik beim Synchronisieren einer externen Datenimpulsfolge auf einen internen Arbeitstakt gleicher Frequenz, jedoch unbestimmter Phasenlage auf. Man möchte die Synchronisierung schnell stabilisieren, um Datenverluste zu vermeiden, andererseits können aber geringe Phasenablagen zwischen externem und internem Takt zu kritischen und undefinierten Schaltzuständen führen.

Der vorliegenden Erfindung liegt daher die Aufgabe zugrunde, eine Synchronisierungseinrichtung der im Oberbegriff des Hauptanspruches genannten Art derart weiterzubilden, daß sie es erlaubt, bei unbekannter Phasenlage der Eingangsimpulsfolge bezüglich des internen Arbeitstaktes mit Sicher-heit solche instabilen Signalzustände auszuschal-ten und auch bei ungünstigen Taktverhältnissen noch eine sichere Betriebsweise gewährleistet.

Diese Aufgabe wird erfindungsgemäß bei einer Synchronisierungseinrichtung nach dem Oberbegriff des Hauptanspruches durch die im Kennzeichen dieses Anspruches bechriebenen Merkmale gelöst.

Erfindungsgemäß wird bei dieser Lösung zunächst bereits im Ruhezustand, d.h. noch vor einer Änderung des Zustandssignales der externe Takt vorbereitend auf die interne Taktsignalfolge kontinuierlich aufsynchronisiert. Dieser in den Ruhezustand verlegte "Fangzustand" erlaubt eine schnelle Umschaltung der Synchronisierungseinrichtung in den synchronisierten Betriebszustand, d.h. den synchronisierten Zustand schnell zu stabilisieren. Andererseits gelingt es mit dieser Lösung, eindeutig einen bestimmten Bereich zu beiden Seiten der steu-ernden Taktflanken des externen Taktes als einen "verbotenen" Bereich zu definieren, in dem eine zufällig auftretende Taktflanke des internen Arbeitstaktes nicht wirksam werden kann. Dies bedeutet mit anderen Worten, daß am Vorbereitungseingang des die synchronisierte Signalimpulsfolge abgebenden Flipflops in jedem Fall der Signalzustand bereits während der Vorbereitungszeit und der darauf folgenden Haltezeit stabil ist. Dies ist aufgrund der Laufzeiten in dem Schaltnetzwerk sichergestellt. Denn eine Flanke des höherfrequenten internen Taktsignales kann erst dann selektiert werden, wenn vorher die durch eine Taktflanke des externen Taktes angesteuerte weitere Schaltstufe umgeschaltet hat. Dies geschieht aber voraussetzungsgemäß immer mit einer vorbestimmten, die Set-Up- und Holdzeiten der eingesetzten Flipflops berück-sichtigenden Verzögerung gegenüber der steuern-den Flanke des externen Taktes.

Die angegebene Lösung ist auch deshalb vorteilhaft, da in vielen Anwendungsfällen ein interner Takt mit einer Frequenz, die einem Vielfachen der Frequenz der empfangenen Signalimpulsfolge entspricht, ohnehin benötigt wird. Wenn auch aus der obengenannten JP-A-58-188 316 ein Frequenzverhältnis von 2:1, vorgegeben durch die Schaltfunktion der dort verwendeten JK-Flipflops, an sich bekannt ist, erlaubt diese Verallgemeinerung ohne großen Aufwand eine Flexibilität der Synchronisierungseinrichtung zu erreichen, bei der durch die Größe der absoluten Phasendifferenz zwischen dem Takt der empfangenen Signalimpulsfolge und dem internen Arbeitstakt keine einschränkende Bedingung vorgegeben ist. Denn zum Aufsynchronisieren des internen Arbeitstaktes ist es an sich völlig von untergeordneter Bedeutung, welche Taktflanke im internen höherfrequenten Taktsignal selektiert wird. Das interne Taktsignal wird im Frequenzteiler immer so heruntergeteilt, daß diese Frequenzteilung der im Anwendungsfall auftretenden Phasendifferenz am besten angepaßt ist.

Erfindungsgemäß ist eine erste Schaltstufe vorgesehen, die durch das Zustandssignal umschaltbar ist und durch den internen Arbeitstakt gesteuert wird. Sie nimmt einen von zwei Schaltzuständen ein, die einen Ruhezustand (Fangzustand) bzw. ei-nen normalen Betriebszustand der Synchronisie-rungseinrichtung festlegen. Abhängig vom Schalt-zustand dieser ersten Schaltstufe ist die weitere Schaltstufe, die den externen Takt mit vorbestimmter Verzögerung bewertet, nur im Fangzustand setzbar. Dieser Fangzustand wird erst nach dem Einsynchronisieren abgeschlossen, da das Zustandssignal erst mit dem bereits synchronisierten internen Arbeitstakt in die erste Schaltstufe übernommen wird. Im normalen Betriebszustand ist dann das Schaltverhalten des Frequenzteilers allein durch das interne Taktsignal bestimmt.

Dies bedeutet, daß die Synchronisierungseinrichtung zunächst immer den Fangzustand einnimmt und sich dabei laufend einsynchronisiert, wobei Taktflanken des externen Taktes nur im Fangzustand ausgewertet werden. Im laufenden Betrieb findet keine andauernde Resynchronisierung statt. So ist es dann nur noch von untergeordneter Bedeutung, wenn die Detektion der Phasenlage nicht während jeder Taktlage eindeutig erfolgen kann. Ein einmal eingefangener Zustand wird dann jedenfalls gehalten, so daß keine undefinierten Zustände auftreten. Dies zielt insbesondere auf den Fall ab, daß auf-einanderfolgende Taktflanken des höherfrequen-

ten internen Taktsignales in Ausnahmefällen bezüglich des der empfangenen Signalimpulsfolge zugeordneten Taktes an sich gleichwertig liegen können und sich dann die Synchronisierungseinrichtung bei ständiger Resynchronisierung an sich beliebig auf die eine oder diese andere dieser beiden Taktflanken des höherfrequenten internen Taktsignales einstellen würde. Ein solches Pendeln der Synchronisierungseinrichtung wäre jedoch während des Synchronbetriebes unvorteilhaft. Aus diesem Grunde werden die zwei Betriebszustände definiert. Der Fangzustand dient einem kontinuierlichen Einsynchronisieren. Beim Übergang vom Fangzustand in den normalen Betriebszustand wird die aktuelle Phasendifferenz dann als ein konstanter Wert dem nachfolgenden Synchronbetrieb zugrundegelegt. Schaltungstechnisch ist das so realisiert, daß der Frequenzteiler alle Schaltelemente des Schaltnetzwerkes definiert umschaltet, also auch sich selbst im Takt seines Ausgangssignales, d.h. des synchronisierten, internen Arbeitstaktes zurücksetzt.

Weiterbildungen der Erfindung ergeben sich aus den Unteransprüchen und sind in der nachfolgenden Beschreibung eines Ausführungsbeispieles noch näher erläutert.

Ein Ausführungsbeispiel der Erfindung wird im folgenden anhand der Zeichnung näher erläutert, dabei zeigt:

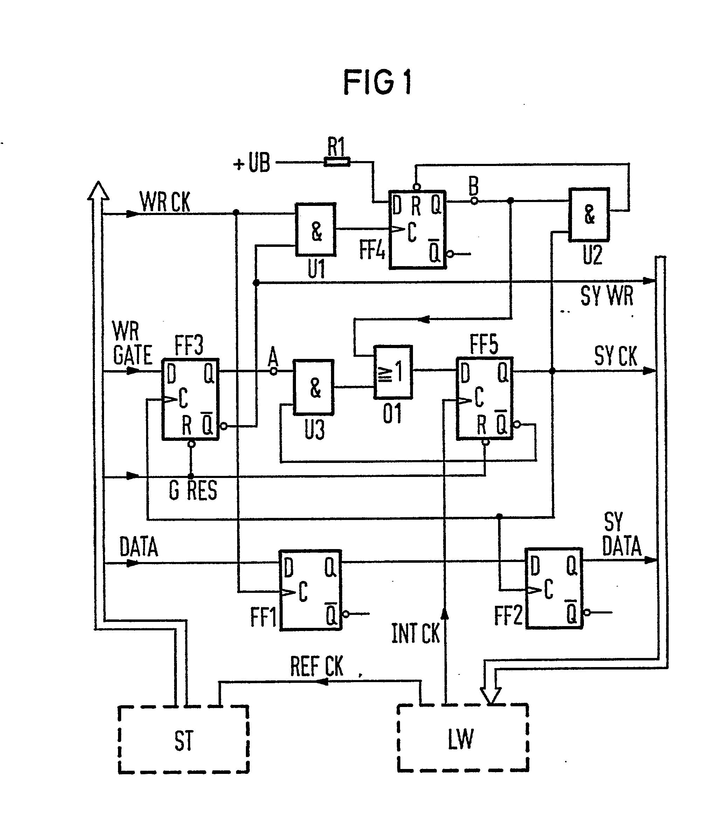

Fig. 1 ein Schaltbild einer Synchronisierungseinrichtung gemäß der Erfindung,
Fig. 2 eine Reihe von Impulsdiagrammen verschiedener, in Fig. I bezeichneter Signale zur Erläuterung eines Fangzustandes der Synchronisierungseinrichtung, in dem ein interner Arbeitstakt auf einen externen Arbeitstakt synchronisiert wird und
Fig. 3 eine weitere Serie von Impulsdiagrammen für in Fig. I bezeichnete Signale zur Erläuterung der Arbeitsweise der Synchronisierungseinrichtung in ihrem zweiten Zustand, dem normalen Betriebszustand.

Für das in Fig. I dargestellte Ausführungsbeispiel einer erfindungsgemäßen Synchronisierungseinrichtung wird deren Verwendung in der Schreib/Lesesteuerung eines Magnetplattenspeichers herangezogen. Bei Magnetplattenspeichern werden die Daten bekanntlich mit einer Frequenz, die der Drehzahl der Speicherplatten eines Speicherlaufwerkes proportional ist, aufgeschrieben. Das Speicherlaufwerk LW mit seiner Mechanik und seiner Schreib/Lese-Elektronik ist in Fig. I nur schematisch als Block dargestellt, da es als bekannt vorausgesetzt werden kann und im vorliegenden Zusammenhang lediglich von untergeordneter Bedeutung ist. Deshalb sei hier nur angedeutet, daß ein der aktuellen Drehzahl eines Plattenspeicherstapels entsprechendes internes Taktsignal INT CK ein verarbeitetes Lesesignal von auf den Speicherplatten gespeicherter Servoinformation ist. Im vorliegenden Fall soll aus einer solchen Servoinformation zunächst dieses interne Taktsignal INT CK gewonnen werden, das im vorliegenden Fall dem doppelten Bittakt entsprechen möge, um ein möglichst gutes Tastverhältnis zu erzielen. Dieses interne Taktsignal wird auf einen Takt, der der Bitfrequenz entspricht, heruntergeteilt und als Referenztakt REF CK zu einer Speichersteuerung ST übertragen. Diese Speichersteuerung, häufig auch als "Controller" bezeichnet, ist das Verbindungsglied des Speicherlaufwerkes LW mit seiner Umgebung, also einem elektronischen System mit datenverarbeitender Funktion. Die Speichersteuerung übernimmt beispielsweise von einem solchen, in Fig. I nicht mehr dargestellten elektronischen System zu speichernde Daten, wandelt diese in serielle NRZ-Schreibdaten DATA um und schickt diese zusammen mit dem Referenztakt, der damit als Schreibtakt WR CK dient, zum Speicherlaufwerk LW zurück.

Die Frequenz des Schreibtaktsignales WR CK und des Referenztaktes REF CK ist damit identisch, wegen der Verzögerungszeiten der Übertragung in beiden Richtungen und der der Elektronik der Speichersteuerung ST tritt aber eine Phasenverschiebung unbekannter Größe auf. Bei heutigen Aufzeichnungs- und Datenübertragungsraten kann die Summe dieser Verzögerungszeiten in der Größenordnung einer Bitperiode liegen, daher ist es nicht ohne weiteres möglich, die Schreibdaten DATA mit dem geräteinternen Referenztakt REF CK zu empfangen und so auf die internen Takte des Laufwerkes aufzusynchronisieren. In diesem Zusammenhang sei darauf hingewiesen, daß intern Takte mit einem Mehrfachen der Frequenz des Referenztaktes erzeugt und z. B. für Datencodierung benötigt werden. Im Spezialfall ist dies die doppelte Taktfrequenz.

Für die Synchronisierung ist die in Fig. I im Detail dargestellte Schaltungsanordnung vorgesehen. Sie enthält zunächst zwei in Serie geschaltete D-Flipflops FFI und FF2, von denen das erstere die von der Speichersteuerung ST zugeführten Schreibdaten DATA, gesteuert durch die positive Flanke des Schreibtaktsignales WR CK, übernimmt. Die entsprechenden Ausgangssignale des ersten D-Flipflops FFI werden zum zweiten D-Flipflop FF2 übertragen und dort, gesteuert durch einen noch zu erläuternden synchronen Bittakt SY CK, zwischengespeichert und als synchronisierte Schreibdaten SY DATA an das Speicherlaufwerk LW abgegeben.

Die Synchronisierungseinrichtung besitzt zwei Funktionszustände, die durch den Betriebszustand eines dritten Flipflops FF3, das als Zustandsflipflop bezeichnet ist, bestimmt sind. Das Zustandsflipflop empfängt an seinem Dateneingang ein von der Speichersteuerung ST abgegebenes Schreibsteuersignal WR GATE, das bei hohem Pegel einen Schreibzustand bzw. bei niedrigem Pegel einen Fangzustand der Synchronisierungseinrichtung festlegt.

Das Schreibtaktsignal WR CK wird außerdem einem ersten UND-Glied UI zugeführt, das außerdem an den inversen Ausgang des Zustandsflipflops FF3 angeschlossen ist und mit seinem Ausgang an den Takteingang eines weiteren D-Flipflops FF4 angeschlossen ist. Dessen Dateneingang ist über einen Widerstand RI mit positiver Betriebsspannung UB verbunden. Der normale Ausgang dieses Flipflops ist einerseits über ein weiteres UND-Glied U2 mit einem Rücksetzeingang dieses Flipflops verbunden und andererseits über ein ODER-Glied OI an den Dateneingang eines weiteren D-Flipflops FF5 angeschlossen. Dieses Flipflop wird durch das von der Elektronik des Speicherlaufwerkes LW erzeugte interne Taktsignal INT CK von doppelter Bitfrequenz gesteuert und gibt das erwähnte synchronisierte Taktsignal SY CK an seinen normalen Ausgang ab.

Der inverse Ausgang des D-Flipflops FF5 ist mit einem Eingang eines weiteren UND-Gliedes U3 verbunden, dessen weiterer Eingang mit dem Normalausgang des Zustandsflipflops FF3 verbunden ist und das ausgangsseitig an einen zweiten Eingang des ODER-Gliedes OI angeschlossen ist. Außerdem besitzt dieses Flipflop FF5 ebenso wie das Zustandsflipflop FF3 einen Rücksetzeingang, beide Rücksetzeingänge sind gemeinsam über eine Steuerleitung mit der Speichersteuerung ST verbunden, die über diese Steuerleitung beim Einschalten ein allgemeines Rücksetzsignal G RES abgibt und damit die Synchronisierungseinrichtung in einen definierten Ausgangszustand versetzt.

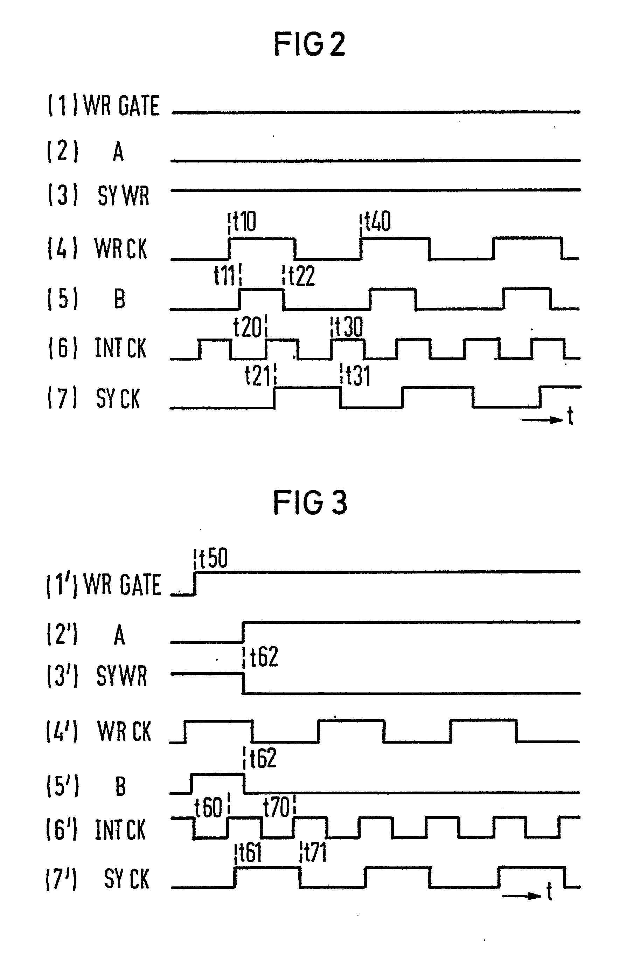

Die Arbeitsweise der beschriebenen Schaltungsanordnung wird nun im folgenden anhand der in den Fig. 2 bzw. 3 dargestellten Impulsdiagramme beschrieben. Die in Fig. 2 dargestellten Impulsdiagramme erläutern dabei den Fangzustand, der, wie erwähnt und in Zeile (I) von Fig. 2 dargestellt, durch den Niedrigpegel des Schreibsteuersignales WR GATE definiert ist. Im Fangzustand ist also das Zustandsflipflop FF3 rückgesetzt, d. h. ein an seinem normalen Ausgang abgegebenes und in Zeile (2) von Fig. 2 dargestelltes Ausgangssignal A liegt auf niedrigem Pegel. Damit ist das dritte UND-Glied U3 deaktiviert. Dagegen ist das am inversen Ausgang des Zustandsflipflops FF3 abgegebene Signal, das synchronisierte Schreibsignal SY WR, im Fangzustand auf hohem Pegel, der seinen inaktiven Zustand kennzeichnet, wie in Zeile (3) von Fig. 2 gezeigt ist.

Im Fangzustand ist damit das erste UND-Glied UI zum Durchschalten des Schreibtaktsignals WR CK auf den Takteingang des D-Flipflops FF4 vorbereitet. Das Schreibtaktsignal WR CK ist in Zeile (4) von Fig. 2 gezeigt und weist zu einem Zeitpunkt tIO eine positive Flanke auf, mit der das D-Flipflop FF4 gesetzt wird. Um die Schaltzeit des Flipflops und des UND-Gliedes UI verzögert, nimmt daher sein normaler Ausgang zu einem Zeitpunkt tII einen Zustand mit hohem Signalpegel ein, wie in Zeile (5) von Fig. 2 gezeigt ist.

Dieses mit B bezeichnete Ausgangssignal des D-Flipflops FF4 ist über das ODER-Glied OI dem Dateneingang des D-Flipflops FF5 zugeführt. Mit der nächsten, zum Zeitpunkt t2O auftretenden positiven Flanke des internen Taktsignales INT CK, das in Zeile (6) von Fig. 2 dargestellt ist, wird diese Eingangsinformation in das D-Flipflop FF5 übernommen. Um die Laufzeit dieses Flipflops verzögert, wird daher zu einem Zeitpunkt t2I die positive Flanke des synchronisierten Taktsignales SY CK erzeugt. Diese wiederum aktiviert das zweite UND-Glied U2, so daß zu einem Zeitpunkt t22 das D-Flipflop FF4 zurückgesetzt wird.

Das Ausgangssignal B, nun mit niedrigem Pegel, bereitet damit das weitere D-Flipflop FF5 vor, das zum Zeitpunkt t3O wieder mit einer positiven Flanke des internen Taktsignals INT CK angesteuert wird. Verzögert um die Schaltzeit dieses Flipflops erscheint daher zum Zeitpunkt t3I die Rückflanke des in Zeile (7) von Fig. 2 dargestellten synchronisierten Taktsignales SY CK.

Solange das Schreibsteuersignal WR GATE seinen Zustand nicht ändert, setzt sich dieser beschriebene Vorgang des Einsynchronisierens, gesteuert durch das Schreibtaktsignal WR CK, fort. Dies bedeutet, daß mit der nächsten positiven Flanke des Schreibtaktsignales WR CK zum Zeitpunkt 4O das D-Flipflop FF4 erneut gesetzt wird.

Aus der vorstehenden Beschreibung der Zeitabläufe während des Fangzustandes wird deutlich, daß die Einzellaufzeiten in den Bauelementen der Synchronisierungseinrichtung eine wesentliche Funktion übernehmen. Dies soll sowohl die Darstellungsweise der Fig. 2, in der die Auswirkung der Laufzeiten in zeitlichem Maßstab übertrieben dargestellt ist, als auch die Bezeichnungsweise für die einzelnen Zeitpunkte verdeutlichen, so beruht beispielsweise der zeitliche Abstand zwischen den Zeitpunkten tIO und tII auf der Summe der Laufzeiten im ersten UND-Glied UI und im D-Flipflop FF4. Ähnliches läßt sich für die Zusammenhänge zwischen den Zeitpunkten t2O bis t22 bzw. t3O und t3I aufgrund der vorstehenden Beschreibung aus Fig. I entnehmen.

Funktionell am bedeutsamsten ist, daß diese Laufzeitbedingungen einen minimalen zeitlichen Abstand zwischen dem Auftreten einer positiven Flanke des Schreibtaktsignales WR CK und dem Wirksamwerden einer dazu phasenverschobenen positiven Flanke des internen Taktsignales INT CK bedingen. Am Beispiel der Impulsdiagramme von Fig. 2 bedeutet dies, daß der zeitliche Abstand zwischen den Zeitpunkten tIO und t2I einen definierten Mindestwert nicht unterschreiten darf, wenn die zum Zeitpunkt t2I auftretende positive Flanke des synchronisierten Taktsignales SY CK wirksam werden soll. Das beruht darauf, daß Vorbereitungs- und Haltezeiten der D-Flipflops FFI bzw. FF2 eingehalten sein müssen, damit keinen undefinierten Zustände auftreten, andernfalls darf die positive Flanke des synchronisierten Taktsignales SY CK nicht schon zum Zeitpunkt t2I sondern erst zum Zeitpunkt t3I auftreten.

Nachfolgend wird nun der zweite Betriebszustand der Schaltungsanordnung, der im gewählten Ausführungsbeispiel dem Schreibzustand entspricht, anhand der in Fig. 3 dargestellten Impulsdiagramme näher erläutert. Die Impulsdiagramme von Fig. 3 beziehen sich auf dieselben Signale, für die Impulsdiagramme bereits in Fig. 2 gezeigt sind.

In Zeile (I') von Fig. 3 ist gezeigt, daß das statische Schreibsteuersignal WR GATE zu einem an sich beliebigen Zeitpunkt t5O einen hohen Pegel annimmt. Damit ist das Zustandsflipflop FF3 vorbereitet und schaltet beim Auftreten der nächsten positiven Flanke des in Zeile (7') dargestellten synchronisierten Taktsignales SY CK um. Fig. 3 zeigt, daß dieser Übergang aus dem Fangzustand in den normalen Betriebszustand durch das Auftreten der nächsten, auf den Zeitpunkt t5O folgenden positiven Flanke des internen Taktsignales INT CK zum Zeitpunkt t6O ausgelöst wird. Dabei wird, wie vorher beschrieben, das D-Flipflop FF5 gesetzt und somit tritt zum Zeitpunkt t6l ein Pegelwechsel des synchronisierten Taktsignales SY CK auf. Dies bewirkt einerseits, daß das D-Flipflop FF4, wie beschrieben, zum Zeitpunkt t62 zurückgesetzt wird und andererseits etwa gleichzeitig das Zustandsflipflop FF3 gesetzt wird. Mit dieser Aktivierung des Zustandsflipflops FF3 wird nun das erste UND-Glied Ul gesperrt. Damit werden für die weitere Funktion der Synchronisierungseinrichtung im normalen Betriebszustand nachfolgende Flankenwechsel des Schreibtaktsignales WR CK unwirksam geschaltet und das D-Flipflop FF4 im rückgesetzten Zustand gehalten. Stattdessen aktiviert nun das Zustandsflipflop FF3 das dritte UND-Glied U3 über das an seinem normalen Ausgang auftretende Ausgangssignal A, dessen Impulsdiagramm in Fig. 3, Zeile 2' dargestellt ist. Damit setzt sich das D-Flipflop FF5 selbst im Takt des internen Taktsignales INT CK und zwar über die Schaltungsverbindung seines inversen Ausganges mit dem Dateneingang über das dritte UND-Glied U3 und das ODER-Glied Ol zurück, wobei das UND-Glied U3 die steuernde Funktion übernimmt.

Diese direkte Kopplung der Synchronisierungseinrichtung an den Verlauf des internen Taktsignales INT CK im normalen Betriebszustand trägt wesentlich zur Eindeutigkeit der Betriebsweise der Schaltungsanordnung bei. Im Fangzustand ist es noch offen, welche der beiden während einer Periode des Schreibtaktsignales WR CK auftretenden positiven Flanken des internen Taktsignales INT CK jeweils zum Auslösen der positiven Taktflanke des synchronisierten Taktsignales SY CK wirksam werden. Dabei kann es vorkommen, daß die Phasenlagen des internen Taktsignales INT CK in bezug auf das Schreibtaktsignal WR CK im Prinzip gleichwertig sind und im Grenzfall wechselweise ausgewählt werden. Im Fangzustand bleibt dies ohne Auswirkung. Im normalen Betriebszustand kann aber ein solcher Fall wegen der Rückkopplung des D-Flipflops FF5 nicht mehr auftreten.

Allgemein bedeutet dies, daß die beschriebene Synchronisierungseinrichtung Daten, die zusammen mit einem Takt übertragen werden und bezüglich eines gleichfrequenten internen Arbeitstaktes einer Empfangseinrichtung eine unbestimmte Phasenlange haben, mit Hilfe eines zu diesem Arbeitstakt gleichphasigen Taktsignales n-facher Frequenz synchronisiert werden. Dabei ist die Hauptbedingung eingehalten, daß die selektierte Flanke des Grundtaktes immer einen vorbestimmten zeitlichen Abstand zur nächstliegenden Flanke des steuernden Taktes im beschriebenen Ausführungsbeispiel des Schreibtaktsignales WR CK aufweisen muß. Mit anderen Worten bedeutet dies, daß im Bereich der steuernden Flanke dieses Taktes ein verbotener Bereich definiert und mit Hilfe der Laufzeiten der Bauelemente der Synchronisierungseinrichtung realisiert wird. Eine aufgrund der unbestimmten Phasenverschiebung zufällig innerhalb dieses Bereiches auftretende Flanke des Grundtaktes kann nicht wirksam werden. Dieser verbotene Bereich ist auf jeden Fall breiter, als es die Vorbereitungs- und Schaltzeiten der beiden, die Datensignale DATA empfangenden bzw. synchronisierte Datensignale SY DATA abgebenden Flipflops FFl bzw. FF2 erfordern. Auch bei unbekannter Phasenlage kann daher nicht der Fall eintreten, daß sich der Signalzustand am Dateneingang des zweiten D-Flipflops FF2 noch innerhalb seiner spezifischen Vorbereitungszeit ändert, die der steuernden Flanke des internen synchronisierten Taktsignales SY CK vorangeht.

Schaltungstechnisch ist dabei insbesondere von Bedeutung, daß Schaltkreislaufzeiten wesentlich für die Funktion sind. Bei integrierten Schaltkreisen können aber solche Laufzeiten eine breite Exemplarstreuung aufweisen. Diese Schwierigkeit läßt sich aber dadurch auf eine sehr elegante Weise aufgrund einer bewußt funktionell ausgenützte Eigenschaft der beschriebenen Lösung eliminieren, wenn man die für die Laufzeiten funktionsbestimmenden Flipflops, also das erste D-Flipflop FFl und das zur Detektion des verbotenen Bereiches eingesetzte Flipflop FF4 der ersten Schaltstufe mit Kippstufen realisiert, die auf einem Baustein liegen. Das könnte bei einem diskreten Schaltungsaufbau ein logischer Schaltkreis mit mehreren D-Flipflops sein. Die Randbedingung wäre aber selbstver ständlich auch eingehalten, falls die gesamte Synchronisierungseinrichtung als integrierter Schaltkreis realisiert wird.

## Patentansprüche

1. Synchronisierungseinrichtung zum Erzeugen einer synchronisierten Impulsfolge (SY DATA) aus einer externen digitalen Signalimpulsfolge (DATA), die bezüglich eines internen Arbeitstaktes (SY CK) gleiche Taktfrequenz, jedoch unbestimmte Phasenlage aufweist, mit Hilfe zweier seriell geschalteter Flipflops (FF1, FF2), von denen das eine, im Takt (WR CK) der externen Signalimpulsfolge gesteuert, deren jeweiligen Signalzustand zwischenspeichert und das andere dadurch vorbereitet wird und die synchronisierte Impulsfolge, ausgelöst durch den internen Arbeitstakt, abgibt, der mit Hilfe eines Schaltnetzwerkes (FF3 bis FF5) abgeleitet wird, das in Abhängigkeit von einem ihm zugeführten Zustandssignal (WR GATE) einen Ruhe- bzw. einen Betriebszustand einnimmt und das einen Frequenzteiler (FF3, U3) aufweist, der im Betriebszustand eine interne Taktsignalfolge (INT CK) untersetzt und, entsprechend dem Zeitpunkt seiner Auslösung, mit einer vorgegebenen Phase der internen Taktsignalfolge beginnend, das untersetzte Taktsignal kontinuierlich als internen Arbeitstakt (SY CK) abgibt, dadurch gekennzeichnet, daß das Schaltnetzwerk folgende Merkmale aufweist:

a) eine erste, bei Vorliegen des Zustandssignales (WR GATE) durch den internen Arbeitstakt in den Betriebszustand umschaltbare Schaltstufe (FF3) und

b) eine weitere, nur im Ruhezustand durch den externen Takt (WR CK) mit einer vorbestimmten Phasenablage gegenüber dem internen Arbeitstakt in einen ersten Zustand steuerbare Schaltstufe (FF4), die dann ein entsprechendes Ausgangssignal (B) abgibt, die durch den internen Arbeitstakt wieder rücksetzbar ist und die den Frequenzteiler (FF5, U3), der die interne Taktsignalfolge (INT CK) mit einer gegenüber dem internen Arbeitstakt n-fachen Frequenz im Verhältnis 1/n, wobei n ≥ 2, untersetzt, durch dieses Ausgangssignal (B) jeweils auslöst.

2. Synchronisierungseinrichtung nach Anspruch 1, dadurch gekennzeichnet, daß die weitere Schaltstufe als Flipflop (FF4) ausgebildet ist, das einen Vorbereitungs- und einen Rücksetzeingang aufweist, wobei der Vorbereitungseingang, fest verdrahtet, auf hohen Pegel gelegt ist und daß ein UND-Glied (U2) vorgesehen ist, dessen Eingängen jeweils das Ausgangssignal (B) der weiteren Schaltstufe bzw. der interne Arbeitstakt (SY CK) zugeführt ist und dessen Ausgang mit dem Rücksetzeingang der weiteren Schaltstufe verbunden ist.

3. Synchronisierungseinrichtung nach Anspruch 1 oder 2, dadurch gekennzeichnet, daß die erste Schaltstufe (FF3) als ein Zustandsflipflop ausgebildet ist, dessen Vorbereitungseingang das Zustandssignal (WR GATE) als statisches Signal und dessen Takteingang der interne Arbeitstakt (SY CK) zugeführt ist und daß ein weiteres UND-Glied (U1) vorgesehen ist, dessen Eingänge an einen im Fangzustand aktivierten Ausgang des Zustandsflipflops (FF3) angeschlossen sind bzw. den der externen Signalimpulsfolge (DATA) zugeordneten Takt (WR CK) empfangen und dessen Ausgang mit dem Takteingang des die weitere Schaltstufe bildenden Flipflops (FF4) verbunden ist.

4. Synchronisierungseinrichtung nach Anspruch 3, gekennzeichnet durch ein drittes UND-Glied (U3), dessen Eingängen das im normalen Betriebszustand aktivierte Ausgangssignal (A) des Zustandsflipflops (FF3) bzw. der interne Arbeitstakt (SY CK) invertiert zugeführt ist und durch ein ODER-Glied (01), dessen Eingänge jeweils mit dem Ausgang des dritten UND-Gliedes (U3) bzw. mit dem das Ausgangssignal (B) führenden Signalausgang der weiteren Schaltstufe (FF4) verbunden sind.

5. Synchronisierungseinrichtung nach Anspruch 4, dadurch gekennzeichnet, daß das Zustandsflipflop (FF3) und das den Frequenzteiler bildende Flipflop (FF5) jeweils einen Rücksetzeingang aufweisen, denen ein externes Rücksetzsignal (G RES) zum definierten Rücksetzen der Flipflops nach dem Einschalten der Synchronisierungsvorrichtung zuführbar ist.

## Claims

1. Synchronizing device for generating a synchronized pulse sequence (SY DATA) from an external digital signal pulse sequence (DATA), which has the same clock frequency as an internal work clock (SY CK), but has an undefined phase relationship, with the assistance of two serially connected flip-flops (FF1, FF2), of which one, driven with the clock (WR CK) of the external signal pulse sequence, intermediately stores the respective signal state thereof, and the other is thereby set up and outputs the synchronized pulse sequence, triggered by the internal work clock, which is derived with the assistance of a switching network (FF3 to FF5) which assumes an idle or an operating state respectively depending on a status signal (WR GATE) supplied to it and which has a frequency divider (FF5, U3) that reduces an internal clock signal sequence (INT CK) in the operating state and, commencing with a predetermined phase of the internal clock signal sequence in accordance with its triggering time, outputs the reduced clock signal continuously as an internal work clock (SY CK), characterized in that the switching network has the following features:

a) a first switching stage (FF3), which can be switched over to the operating state by the internal work clock when the status signal (WR GATE) appears, and

b) a further switching stage (FF4) which can be driven only in the idle state to a first state by the external clock (WR CK) with a predetermined phase relationship with respect to the internal work clock, and which then outputs a corresponding output signal (B), which can be reset again by the internal work clock and which triggers in each case with this output signal (B) the frequency divider (FF5, U3) which reduces the internal clock signal sequence (INT CK) with an n-times frequency with respect to the internal work clock at a ratio of 1/n, where n ≥ 2.

2. Synchronizing device according to Claim 1, characterized in that the further switching stage is designed as a flip-flop (FF4) having a set-up and a reset input, the set-up input, with fixed wiring, being connected to a high level, and in that an AND gate (U2) is provided, the inputs of which are in each case supplied with the output signal (B) of the further switching stage and the internal work clock (SY CK), respectively, and the output of which is connected to the reset input of the further switching stage.

3. Synchronizing device according to Claim 1 or 2, characterized in that the first switching stage (FF3) is designed as a status flip-flop, the set-up input of which is supplied with the status signal (WR GATE) as a static signal, and the clock input of which is supplied with the internal work clock (SY CK), and in that a further AND gate (U1) is provided, the inputs of which are connected to an output of the status flip-flop (FF3) activated in the acquisition state, or receive the clock (WR CK) associated with the external signal pulse sequence (DATA), and the output of which is connected to the clock input of the flip-flops (FF4) forming the further switching stage.

4. Synchronizing device according to Claim 3, characterized by a third AND gate (U3), the inputs of which are supplied inverted with the output signal (A), activated in the normal operating state, of the status flip-flop (FF3) or the internal work clock (SY CK), respectively, and by an OR gate (01), the inputs of which are in each case connected to the output of the third AND gate (U3) or to the signal output of the further switching stage (FF4) carrying the output signal (B).

5. Synchronizing device according to Claim 4, characterized in that the status flip-flop (FF3) and the flip-flop (FF5) forming the frequency divider in each case have a reset input, to which an external reset signal (G RES) can be supplied for the defined resetting of the flip-flop after the synchronizing device has been switched on.

**Revendications**

1. Dispositif de synchronisation servant à produire une suite d'impulsions synchronisée (SY DATA) à partir d'une suite numérique externe de signaux (DATA), qui possède la même fréquence qu'une cadence interne de travail (SY CK), mais une position de phase indéterminée, à l'aide de deux bascules bistables (FF1, FF2) branchées en série, dont l'une, commandée avec la cadence (WR CK) de la suite externe d'impulsions de signaux, mémorise temporairement l'état respectif de signal de cette suite, et dont l'autre est préparé de ce fait et délivre la suite d'impulsions synchronisée, d'une manière déclenchée par la cadence interne de travail, qui est obtenue au moyen d'un réseau de commutation (FF3 à FF5), qui prend, en fonction d'un signal d'état (WR GATE) qui lui est envoyé, un état de repos ou un état de service et qui contient un diviseur de fréquence (FF5, U3), qui, à l'état de fonctionnement, réduit la fréquence d'une suite interne de signaux de cadence (INT CK) et, en commençant à l'instant de son déclenchement avec une phase prédéterminée de la suite interne de signaux de cadence, délivre de façon continue le signal de cadence, dont la fréquence est réduite, en tant que cadence interne de travail (SY CK), caractérisé par le fait que le réseau de commutation possède les caractéristiques suivantes:

a) un premier étage de commutation (FF3) qui peut être commuté par la cadence interne de travail dans l'état de fonctionnement lors de la présence du signal d'état (WR GATE), et

b) un autre étage de commutation (FF4), qui, uniquement à l'état de repos, peut être placé, d'une manière commandée par la cadence externe (WR CK), avec une position de phase prédéterminée par rapport à la cadence interne de travail, dans un premier état et délivre alors un signal de sortie correspondant (A), qui peut être à nouveau ramené à l'état initial par la cadence interne de travail et déclenche respectivement au moyen de ce signal de sortie (B) le diviseur de fréquence (FF5, U3), qui réduit dans le rapport 1/n, avec n ≥ 2, la cadence interne des signaux de cadence (INT CK) possédant une fréquence n fois supérieure à la cadence interne de travail.

2. Dispositif de synchronisation suivant la revendication 1, caractérisé par le fait que l'autre étage de commutation est réalisé sous la forme d'une bascule bistable (FF4), qui possède une entrée de préparation et une entrée de remise à l'état initial, une entrée de préparation câblée de façon fixe étant placée à un niveau haut, et qu'il est prévu un circuit ET (U2), aux entrées duquel sont envoyés respectivement le signal de sortie (B) de l'autre étage de commutation et la cadence interne de travail (SY CK) et dont la sortie est reliée à l'entrée de remise à l'état initial de l'autre étage de commutation.

3. Dispositif de synchronisation suivant la revendication 1 ou 2, caractérisé par le fait que le premier étage de commutation (FF3) est réalisé sous la forme d'une bascule bistable d'état, à l'entrée de préparation de laquelle est envoyé le signal d'état (WR GATE) constituant un signal statique et à l'entrée de cadence de laquelle est envoyée la cadence interne de travail (SY CK), et qu'il est prévu un autre circuit ET (U1), dont les entrées sont raccordées à une sortie, activée à l'état positionné, de la bascule bistable d'état (FF3) ou reçoivent la cadence (WR CK) associée à la suite externe d'impulsions de signaux (DATA) et dont la sortie est reliée à l'entrée de cadence de la bascule bistable (FF4) formant l'autre étage de commutation.

4. Dispositif de synchronisation suivant la revendication 3, caractérisé par un troisième circuit ET (U3), aux entrées duquel sont envoyés le signal de sortie (A), activé dans l'état normal de fonctionnement, de la bascule bistable d'état (FF3) et la cadence interne de travail (SY CK) à l'état inversé, et par un circuit OU (01), dont les entrées sont raccordées respectivement à la sortie du troisième circuit ET (U3) ou à la sortie de signaux, qui transmet le signal de sortie (B), de l'autre étage de commutation (FF4).

5. Dispositif de synchronisation suivant la revendication 4, caractérisé par le fait que la bascule bistable d'état (FF3) et la bascule bistable (FF5) formant le diviseur de fréquence possèdent des entrées respectives de remise à l'état initial, auxquelles peut être envoyé un signal extérieur de remise à l'état initial (G RES) servant à ramener à l'état initial, d'une manière définie, la bascule bistable après le branchement du dispositif de synchronisation.

# FIG 1

EP 0 216 113 B1

## FIG 2

(1) WR GATE

(2) A

(3) SY WR

(4) WR CK — t10, t40

(5) B — t11, t22

(6) INT CK — t20, t30

(7) SY CK — t21, t31

→ t

## FIG 3

(1') WR GATE — t50

(2') A

(3') SY WR — t62

(4') WR CK

(5') B — t62

(6') INT CK — t60, t70

(7') SY CK — t61, t71

→ t